Europäisches Patentamt

European Patent Office

Office européen des brevets

(11) Publication number : **0 460 834 A1**

## EUROPEAN PATENT APPLICATION

(21) Application number : 91304681.9

(51) Int. Cl.⁵ : **H05K 13/04**

(22) Date of filing : 23.05.91

(30) Priority : 25.05.90 JP 134158/90

(43) Date of publication of application :
11.12.91 Bulletin 91/50

(84) Designated Contracting States :
DE FR GB

(71) Applicant : SONY CORPORATION
7-35 Kitashinagawa 6-Chome Shinagawa-ku
Tokyo 141 (JP)

(72) Inventor : Ohno, Katsuhiko
c/o Sony Corporation, 7-35 Kitashinagawa
6-chome
Shinagawa-ku, Tokyo (JP)
Inventor : Miyata, Hitoshi
c/o Sony Corporation, 7-35 Kitashinagawa
6-chome
Shinagawa-ku, Tokyo (JP)

(74) Representative : Nicholls, Michael John et al
J.A. Kemp & Co., 14, South Square, Gray's Inn
London WC1R 5EU (GB)

(54) Electronic part taking out apparatus.

(57)    An electronic part taking out apparatus which can prevent jumping out of a very small part from a double tape from which the part is exposed. The apparatus comprises a movable tape holder which accepts a double tape in a tape transporting direction and discharges an upper face tape and a mount tape of the double tape therefrom, a moving mechanism for moving the tape holder in the tape transporting direction by a distance equal to a part enclosing distance of the double tape from a home position together with the double tape in synchronism with the operation of the tape transport mechanism and further moving the tape holder in the opposite direction to the home position independently of the tape transport mechanism, and an upper face tape pulling mechanism for pulling the upper face tape in synchronism with the operation of the tape holder in the opposite direction to exfoliate the upper face tape from the mount tape to expose a part on the mount tape. The tape holder is constructed in such a manner as to surround the thus exposed part.

EP 0 460 834 A1

FIG. 1

This invention relates to an electronic part taking out apparatus (part cassette) for taking out electronic parts or chips such as very small thin film resistors or capacitors enclosed at a predetermined distance in a double tape and mounting the thus taken out electronic parts or chips onto an electronic circuit board.

In order to automatically mount an electronic part onto an electronic circuit board, a double tape wherein a plurality of parts are enclosed between a mount tape and an upper face tape along the length thereof is produced in advance. An electronic part taking out apparatus exfoliates the upper face tape from the mount tape to automatically expose the parts successively on the mount tape. The exposed parts are chucked by a vacuum chucking mechanism and transported to a location on and mounted onto a surface of a desired electronic circuit board.

In such electronic part taking out apparatus, it is a problem that a part of a light weight exposed on the mount tape of the double tape jumps out from the mount tape and the electronic part taking out apparatus due to vibrations or an impact caused by operation or movement of the electronic part taking out apparatus before it is chucked by the vacuum chucking mechanism. Thus, various devices have been developed to prevent such jumping out of exposed electronic parts.

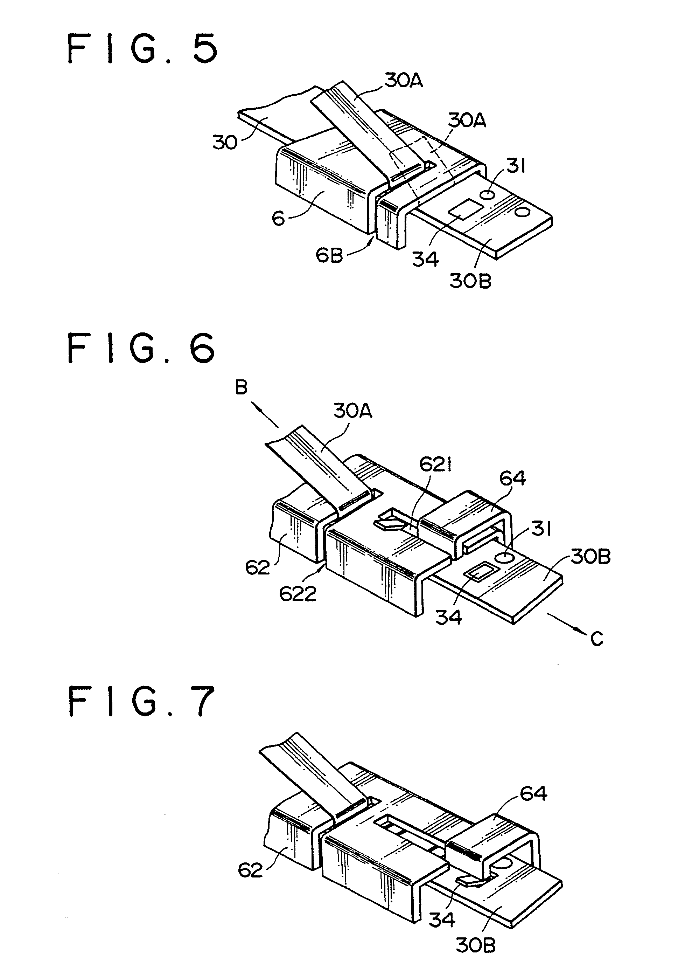

Figs. 6 and 7 show part of an exemplary one of conventional electronic part taking out apparatus which exfoliates an upper face tape from a mount tape of a double to expose parts from the double tape. Referring to Fig. 6, a shutter 64 serving as a part holder is slidably moved in a slit 621 of a fixed tape holder 62.

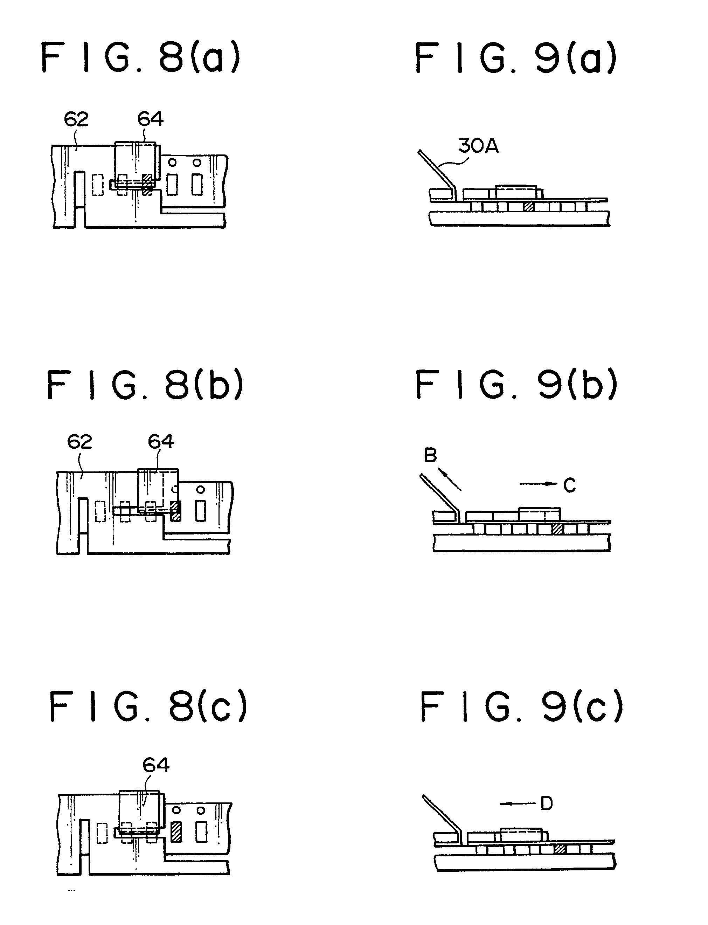

Figs. 8A to 8C and 9a to 9C illustrate different steps of a tape exfoliating operation with the electronic part taking apparatus shown in Fig. 6. After a point of time at which a preceding chucking operation by a vacuum chucking mechanism not shown is completed (Fig. 8A and Fig. 9A), a mount tape 30B of a double tape is transported in the direction indicated by an arrow mark C in Fig. 6 by a tape transporting gear (not shown) engaging with sprocket holes 31 perforated in a longitudinal row in the double tale (Fig. 8B and Fig. 9B). Meanwhile, an upper face tape 30A of the double tape is wound up by a take-up reel (not shown) in synchronism with such transportation of the mount tape 30B, and consequently, it is advanced in the direction indicated by another arrow mark B, whereupon it is exfoliated from the mount tape 30B thereby to expose a part of the double tape below the tape holder 62. Also the shutter 64 is moved in the direction of the arrow mark C together with the mount tape 30B thereby to prevent the part 34 thus exposed below the tape holder 62 from jumping out from the mount tape 30B during the movement of the mount tape 30B. After then (Fig. 8C and Fig. 9C), such transportation of the mount tape 30B is stopped at a certain position, and then, the shutter 64 is retracted in the direction indicated by an arrow mark in Fig. 9D in the slit 621 in the tape holder 62 so that a part indicated by hatching lines in Figs. 8C and 9C may be chucked by the vacuum chucking mechanism, thereby making preparations for the prevention of jumping out of a next part. After then, the sequence of operations described above is repeated. The part chucked by the vacuum chucking mechanism is transported to a location on and mounted onto a surface of a desired electronic circuit board not shown.

Meanwhile, a similar part cassette and electronic part taking out apparatus are disclosed in Japanese Patent Laid-Open Application No. 60-24100. The electronic part taking out apparatus is constituted such that, in place of the construction described above wherein the part jumping out preventing shutter 64 is moved in the slit 621 of the tape holder 62, a shutter for the prevention of jumping out of a part is moved while covering over an entire area of a mount tape of a double tape.

Any of those electronic part taking out apparatus, however, cannot still solve jumping out of a part.

In the first conventional electronic part taking out apparatus described above with reference to Figs. 6 to 9C, a very small part sometimes jumps out from the slit 621 of the fixed tape holder 62 as seen in Fig. 6. If the width of the slit 621 is decreased, then jumping out of a part from the slit 621 will be prevented to a certain degree, but in order to allow the shutter 64 to move in the slit 621 with a predetermined clearance, the width of the slit 621 cannot be decreased smaller than a certain degree. Or, even if the thickness of the shutter 64 is otherwise increased, it is necessary to assure a clearance. Particularly, there is a tendency that a part is progressively decreased in size in accordance with a demand for further improvement in mounting density of parts on an electronic circuit board. Thus, a part is reduced in size to 1 mm X 0.5 mm or less and also in weight. Accordingly, a part exposed from the double tape in the tape holder 62 is likely moved by vibrations of the electronic part taking out apparatus and jumps out from the slit 621. Meanwhile, since there is a play in a lateral direction of the double tape, that is, in a direction perpendicular to the direction in which the double tape and the electronic parts accommodated in the double tape are transported, between the mount tape 30B of the double tape and the tape holder 62 and the mount tape 30B may be displaced in a lateral direction by a greater distance than the size of a part, a part of a very small size sometimes jumps out from the slit 62 due to such displacement. Further, also there is the possibility that a part is displaced and lifted upwardly from the mount tape 30B of the double tape as seen in Fig. 7.

On the other hand, the electronic part taking out apparatus disclosed in Japanese Patent Laid-Open Application No. 60-24100 involves no such slip as described above and hence is free from the problem of jumping out of a part from a slit. However, when the part jumping out preventing shutter is moved to a position at which a part is to be chucked by a vacuum chucking mechanism, the distance between the position at which an upper face tape of a double tape is exfoliated from a mount tape of the double tape and the position to which the shutter has been moved is great, and accordingly, a part exposed at the location of the great distance sometimes jumps out by an impact or the like applied thereto.

It is an object of the present invention to provide an electronic part taking out apparatus which can prevent jumping out of a very small part from a double tape from which the part is exposed.

In order to attain the object, according to the present invention, an electronic part taking out apparatus is constructed such that a part exposed on a mount tape of a double tape by exfoliating an upper face tape of the double tape from the mount tape is not substantially exposed to the outside until it is taken out from the mount tape by a vacuum chucking mechanism or the like.

In particular, according to the present invention, there is provided an electronic part taking out apparatus which comprises a tape transport mechanism for transporting a double tape, which includes an upper face tape and a mount tape between which a plurality of parts are enclosed at a predetermined part enclosing distance, by a distance equal to the part enclosing distance in a tape transporting direction, movable tape holder means including means for accepting such double tape in the tape transporting direction and discharging the upper face tape and the mount tape of the double tape therefrom, a tape holder moving mechanism for moving the tape holder means in the tape transporting direction by a distance equal to the part enclosing distance from a home position together with the double tape in a synchronized relationship to the operation of the tape transport mechanism and further moving the tape holder means in the opposite direction to the home position independently of the tape transport mechanism, and an upper face tape pulling mechanism for pulling the upper face tape in a synchronized relationship to the operation of the tape holder means in the opposite direction to exfoliate the upper face tape from the mount tape to expose a part on the mount tape, the tape holder means further including means for surrounding the thus exposed part. Preferably, the tape holder means has a U-shaped transverse section and has only an upper face tape discharging slit formed therein perpendicularly to the tape transporting direction.

The tape holder moving mechanism and the tape transport mechanism operate in a synchronized relationship with each other to move the double tape introduced in the tape holder and the tape holder, respectively, in the same direction by a distance equal to the part enclosing distance. Consequently, a part which will make an object for the chucking by a vacuum chucking mechanism or the like is positioned at a chucking position. While the tape transport mechanism stops transportation of the double tape there, the tape holder moving mechanism moves the tape holder means in the opposite direction to the home position. In a synchronized relationship to the operation of the tape holder moving mechanism in the opposite direction, the upper face tape pulling mechanism pulls the upper face tape thereby to exfoliate the upper face tape from the mount tape. As a result of the movement of the tape holder means in the opposite direction, a part which makes an object for a subsequent chucking operation is exposed fully to the outside of the tape holder means to enable subsequent chucking thereof by the vacuum chucking mechanism. On the other hand, the part exposed on the mount tape as a result of the exfoliation of the upper face tape described above remains in the inside of the tape holder and is not exposed to the outside of the tape holder means. Then, since transportation of the tape is performed in synchronism with movement of the tape holder, the exposed part remains, also during the transportation described above, in a surrounded condition by the tape holder means. In other words, except the fact that a part which makes an object for a next chucking operation is exposed at the chucking position, any other part exposed on the mount tape is not exposed to the outside of the tape holder means, and consequently, possible jumping out such exposed part or parts is prevented even if the electronic part taking out apparatus is vibrated.

The above and other objects, features and advantages of the present invention will become apparent from the following description and the appended claims, taken in conjunction with the accompanying drawings in which like parts or elements are denoted by like reference characters.

Fig. 1 is a side elevational view of an electronic part taking out apparatus showing a preferred embodiment of the present invention;

Fig. 2 is a partial enlarged perspective view showing a tape holder of the electronic part taking out apparatus of Fig. 1;

Figs. 3A to 3C and 4A to 4C are plan views and vertical sectional views, respectively, illustrating operation of the tape holder of Fig. 2;

Fig. 5 is a partial perspective view showing a modification to the tape holder shown in Fig. 2;

Figs. 6 and 7 are perspective views showing part of a conventional electronic part taking out apparatus at different positions: and

Figs. 8A to 8C and 9A to 9C are plan views and vertical sectional views, respectively, illustrating operation of the electronic part taking out apparatus of Figs. 6 and 7.

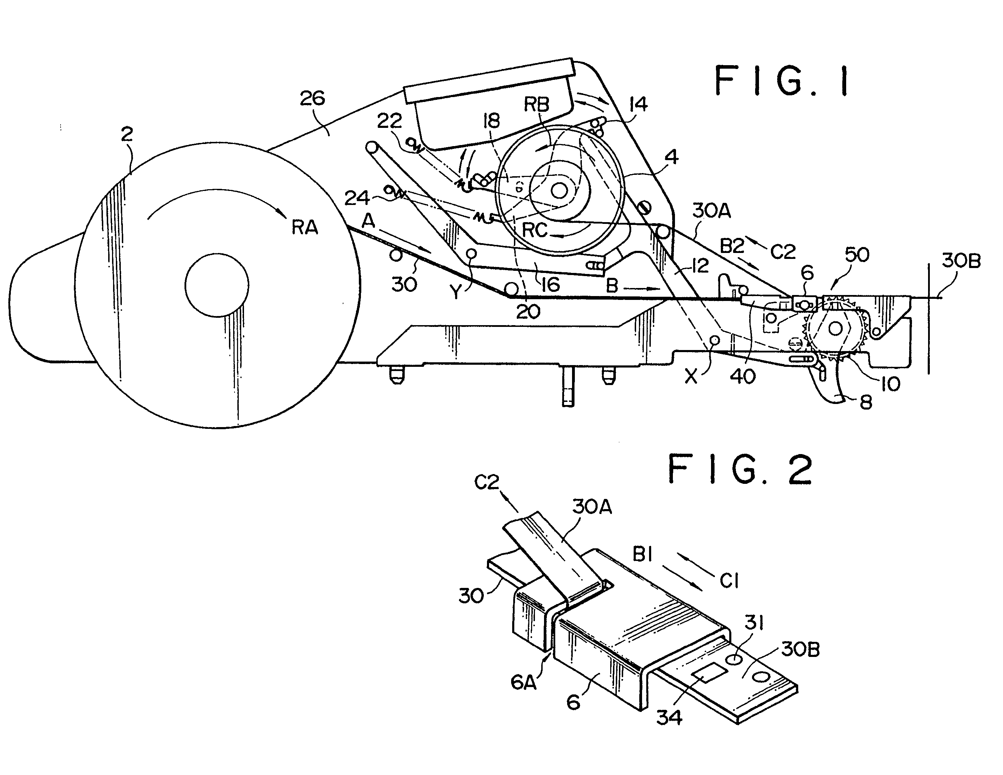

Referring first to Fig. 1, there is shown an electronic part taking out apparatus according to the present invention. The electronic part taking out apparatus shown includes a part reel 2 and a take-up reel 4 mounted for rotation on a mounting base 26. A double tape 30 consisting of a mount tape 30B and an upper face tape 30A between which a plurality of electronic parts are enclosed at a predetermined distance (hereinafter referred to as part enclosing distance) is wound around the part reel 2. A tape cover 40 and a tape holder 6 which has an inverted U-shape transverse section are provided in a tape transport route between the part reel 2 and the take-up reel 4. While the tape cover 40 is fixed, the tape holder 6 is mounted for forward and backward movement in a direction in which the double tape 30 is transported.

Referring now to Fig. 2, the tape holder 6 has such a structure that it accepts the double tape 30 from an entrance thereof and discharges the mount tape 30B of the double tape 30 from an exit thereof while it discharges the upper face tape 30A of the double tape 30 from an upper exit (upper face tape discharging slit) 6A. The tape holder 6 is driven by a feed lever 8.

A plurality of sprocket holes 31 are perforated at a predetermined distance in a longitudinal row along a side edge of the double tape 30 and are engaged by a gear 10 (Fig. 1) which is rotated by operation of the feed lever 8 to feed the double tape 30.

Referring back to Fig. 1, a lever 12 is mounted for pivotal motion around a pivot shaft X and connected to the feed lever 8, and a ratchet pawl 14 is provided at an end of the lever 12. Another lever 16 for the manual feeding operation is mounted for pivotal motion around another pivot shaft Y and connected to the lever 12. Further, in order to rotate the take-up reel 4 forwardly or backwardly, a lever 18, a spring 22, another lever 20 and another spring 24 are provided.

Referring to Figs. 1 and 2, in operation, when the feed lever 8 is operated, the gear 10 is angularly rotated to pull the double tape 30 by way of the sprocket holes 31 of the tape 30 engaged therewith. Consequently, the part reel 2 is rotated in a direction indicated by an arrow mark RA in Fig. 1 while keeping the tension of the tape 30 to a predetermined value. The double tape 30 is thus introduced into the tape holder 6 past the fixed tape cover 40, and then the upper face tape 30A of the double tape 30 is passed through the upper tape discharging slit 6A of the tape holder 6 and is wound up onto the take-up reel 4, whereupon it is exfoliated from the mount tape 30B.

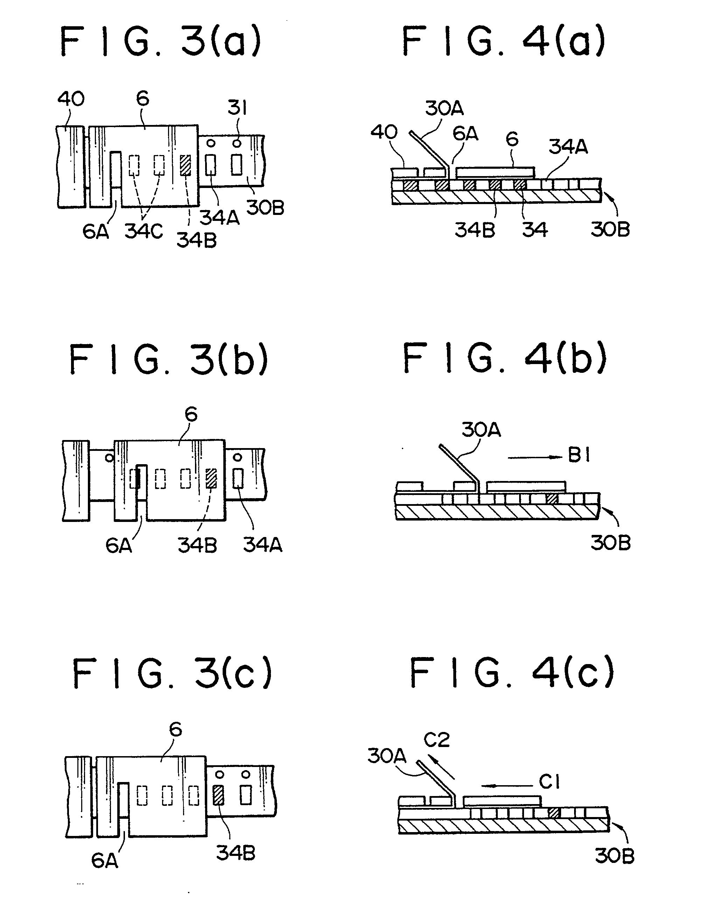

More particularly, referring to Figs. 3A and 4A, the tape holder 6 and the double tape 30 immediately after an exposed part is chucked by a vacuum chucking mechanism not shown. A part mark 34A after removal of a part remains on the mount tape 30B and a chucking object part 34B to be chucked subsequently and further parts 34C which are exposed already but are to be chucked after then are positioned below the tape holder 6 at its home position.

When the feed lever 8 is operated for a first stroke (called first operation) in preparation for a next chucking operation by the vacuum chucking mechanism, the gear 10 transports, at a point of time of the first operation of the feed lever 8, the base tape 30B, which extends through the tape holder 6, by a distance equal to the part enclosing distance in the direction indicated by an arrow mark B1 in Figs. 2 and 4B by way of the sprocket holes 31 of the double tape 30 engaged therewith. In a synchronized relationship with such tape transportation, the tape holder 6 is moved by a distance equal to the part enclosing distance in the same direction of the arrow mark B1. In this instance. since the upper face tape 30A of the double tape 30 which makes an object for the exfoliation is not yet exfoliated and is introduced into the tape holder 6 as part of the double tape 30, the upper lace tape 30A is moved in the direction of the arrow mark B1 together with the mount tape 30B the tape holder 6. In other words, the double tape 30 is moved as a whole in the direction of the arrow mark B1 together with the tape holder 6. During such movement, the exposed parts 34C positioned below the tape holder 6 are surrounded by the tape holder 6, and only a clearance a little greater than the thickness of the upper face tape 30A is present between the exposed parts 34C and the tape holder 6. Accordingly, even if an impact is applied to the electronic part taking out apparatus during such movement, the exposed parts 34C will not hop nor jump out to the outside of the tape holder 6.

In this instance, the take-up reel 4 is rotated backwardly in the direction of the arrow mark RB by a distance equal to the distance over which the upper tape 30A has been advanced in the direction of the arrow mark B1 in Fig. 2. Such backward operation is performed smoothly by the lever 12, ratchet pawl 14 which is operated by the lever 12, lever 18 and spring 22, and lever 20 and spring 24.

When the feed lever 8 stops its feeding operation (called second operation), the tape holder 6 is returned in the direction indicated by an arrow mark C1 in Figs. 2 and 4C to the home position while the mount tape 30B is kept stopped at the thus fed position as seen in Figs. 3C and 4C. As a result of such returning operation of the tape holder 6, the chucking object part 34B is exposed to the outside of the tape holder 6. The vacuum chucking mechanism mentioned hereinabove is located above the thus exposed chucking object part 34B. During the second operation of the feed lever 8, the take-up reel 4 is rotated forwardly in the direction indicated by an arrow mark RC by way of the lever 12, ratchet pawl 14, lever 18 and spring 22, and lever 20 and spring 24 to wound the upper face tape 30A therearound. By such winding operation of the take-up reel 4, the upper lace tape 30A of the double tape 30 is exfoliated from the mount tape 30B so that a new part is exposed below the tape holder 6.

Then, the chucking object part 34B is chucked by the vacuum chucking mechanism. After then, the sequence of operations described above is repeated.

As apparent from the foregoing description, the electronic parts 34C exposed as a result of exfoliation of the upper lace tape 30A from the mount tape 30B of the double tape 30 below the tape holder 6 remain below the tape holder 6 for the entire period of the operations. Accordingly, even if vibrations or an impact takes place with the electronic part taking out apparatus, the exposed parts 34C below the tape holder 6 will not jump out to the outside of the tape holder 6.

It is to be noted that, while operation of the feed lever 8 is divided into the first and second operations, the operations of the feed lever 8 are actually performed as a single continuous stroke operation, and the gear 10 and so forth make operations corresponding to the first and second operations.

In the electronic part taking out apparatus shown in Fig. 2, the upper face tape discharging slit 6A serving as a discharging opening for the upper face tape 30A is shown provided at a location a little spaced from an end of the tape holder 6 on the upstream side of the passage of the tape 30. Such upper lace tape discharging slit, however, may be provided at a different portion of the tape holder 6. Fig. 5 shows a tape holder 6 having such a modified upper face tape discharging slit. Referring to Fig. 5, a discharging slit 6B for an upper face tape 30A of a double tape 30 is provided in the neighborhood of an end of the tape holder 6 on the downstream side of the passage of the tape 30. Consequently, the number of parts which are exposed and transported below the tape holder 6 is reduced, for example, to one, and hopping or jumping out of parts is prevented more effectively.

More typically, as indicated by broken lines in Fig. 5, the upper face tape 30A can be taken out from the end of the tape holder 6 on the downstream side such that only a part to be chucked by vacuum is exposed at a position to which it has been transported. In this instance, it is also possible to omit such upper face tape discharging slits 6A and 6B as shown in Figs. 2 and 5, respectively.

Having now fully described the invention, it will be apparent to one of ordinary skill in the art that many changes and modifications can be made thereto without departing from the spirit and scope of the invention as set forth herein.

## Claims

1. An electronic part taking out apparatus, comprising a tape transport mechanism for transporting a double tape, which includes an upper face tape and a mount tape between which a plurality of parts are enclosed at a predetermined part enclosing distance, by a distance equal to the part enclosing distance in a tape transporting direction, movable tape holder means including means for accepting such double tape in the tape transporting direction and discharging the upper face tape and the mount tape of the double tape therefrom, a tape holder moving mechanism for moving said tape holder means in the tape transporting direction by a distance equal to the part enclosing distance from a home position together with the double tape in a synchronized relationship to the operation of said tape transport mechanism and further moving said tape holder means in the opposite direction to the home position independently of said tape transport mechanism, and an upper face tape pulling mechanism for pulling the upper face tape in a synchronized relationship to the operation of said tape holder means in the opposite direction to exfoliate the upper face tape from the mount tape to expose a part on the mount tape, said tape holder means further including means for surrounding the thus exposed part.

2. An electronic part taking out apparatus according to claim 1, wherein said tape holder means has a U-shaped transverse section and has only an upper face tape discharging slit formed therein perpendicularly to the tape transporting direction.

# FIG. 1

# FIG. 2

EP 0 460 834 A1

# F I G. 3(a)

# F I G. 4(a)

# F I G. 3(b)

# F I G. 4(b)

# F I G. 3(c)

# F I G. 4(c)

# F I G. 5

# F I G. 6

# F I G. 7

# F I G. 8(a)

# F I G. 9(a)

# F I G. 8(b)

# F I G. 9(b)

# F I G. 8(c)

# F I G. 9(c)

**European Patent Office**

## EUROPEAN SEARCH REPORT

Application Number

EP 91 30 4681

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 223 505 (FUJI)<br>* Column 11, line 34 - column 13, line 19; figure 7 *<br>--- | 1 | H 05 K 13/04 |
| A | US-A-4 586 670 (VANCELETTE)<br>* Column 5, line 16 - column 6, line 10; figures 10,11 *<br>----- | 1,2 | |
| | | | **TECHNICAL FIELDS SEARCHED (Int. Cl.5)**<br><br>H 05 K<br>H 01 L |

The present search report has been drawn up for all claims

| Place of search | Date of completion of the search | Examiner |
|---|---|---|
| THE HAGUE | 06-09-1991 | BOLDER G.J.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                  

& : member of the same patent family, corresponding document

EPO FORM 1503 03.82 (P0401)